# EUROPEAN PATENT SPECIFICATION

(11) **EP 2 666 552 B1**
(45) Date of publication and mention of the grant of the patent: **08.07.2015**
(21) Application number: 13167904.5
(22) Date of filing: 15.05.2013
(51) Int. Cl.: B08B 3/12, H01L 21/02

(54) **Ultrasonic cleaning method and ultrasonic cleaning apparatus**
Ultraschallreinigungsverfahren und Ultraschallreinigungsvorrichtung
Procédé et appareil de nettoyage par ultrasons

(30) Priority: 24.05.2012 JP 2012118633
(43) Date of publication of application: 27.11.2013
(73) Proprietor: Siltronic AG, 81737 München (DE)
(72) Inventor: Kubo, Etsuko, Yokkaichi, Mie 512-1306 (JP); Haibara, Teruo, Hikari, Yamaguchi 743-0011 (JP); Mori, Yoshihiro, Nakagyo-ku, Kyoto 604-8457 (JP); Uchibe, Masashi, Izumo, Shimane 693-0062 (JP)
(74) Representative: Baar, Christian

(56) References cited:
- EP-A1- 0 860 866
- US-A- 5 985 811
- US-A- 6 039 055
- US-A1- 2005 081 884
- US-A1- 2006 061 225

## Description

### Technical Field

The present invention relates to an ultrasonic cleaning method and an ultrasonic cleaning apparatus, and particularly to an ultrasonic cleaning method and an ultrasonic cleaning apparatus for cleaning an object to be cleaned in a liquid in which a gas is dissolved, by irradiating the liquid with ultrasonic waves.

### Background Art

In a process of manufacturing a substrate such as a silicon wafer, a substrate cleaning process of an immersion type, a single wafer type or the like has been conventionally conducted in order to remove, from the substrate, organic substances, metallic impurities, particles, natural oxide films and the like that cause a defect in a semiconductor device.

In the substrate cleaning process, various types of cleaning methods have been used depending on its purpose. Particularly when the immersion-type cleaning method is used to remove foreign substances such as particles, use is made of a method for immersing the substrate in a cleaning liquid contained in a cleaning tank and irradiating the cleaning liquid in which the substrate is immersed with ultrasonic waves having a frequency of around 1 MHz, which is called megasonic. It is generally believed that when the ultrasonic waves having a frequency of around 1 MHz are used, damage to the substrate can be reduced and the cleaning effect on submicron-size fine particles on the substrate surface can be increased.

It has been known that a concentration of a dissolved gas in the cleaning liquid affects the efficiency of removal of the foreign substances such as particles. It has been found that when ultrapure water is used as the cleaning liquid and the ultrapure water is irradiated with megasonic to remove the particles from the substrate, for example, a rate of removal of the particles from the substrate is affected by a dissolved nitrogen concentration in the cleaning liquid. More specifically, when the dissolved gas concentration in the cleaning liquid is within a prescribed range, the rate of removal of the particles from the substrate is relatively high (Japanese Patent Laying-Open Nos. JP10-109072A and JP2007-250726A). Therefore, by monitoring the dissolved gas concentration such as the dissolved nitrogen concentration in the cleaning liquid and controlling the dissolved gas concentration in the cleaning liquid to fall within a certain range in the cleaning process, it becomes theoretically possible to remove the particles effectively.

On the other hand, there is a report that the behavior of removal of the particles from the substrate is somehow related to the behavior of weak light emission (sonoluminescence) that occurs when the cleaning liquid is irradiated with the ultrasonic waves ("Behaviour of a Well Designed Megasonic Cleaning System", Solid State Phenomena Vols.103-104 (2005) pp.155-158; "Megasonics: A cavitation driven process", Solid State Phenomena Vols.103-104 (2005) pp.159-162).)

### Problems to be Solved by the Invention

As a result of studies on ultrasonic cleaning of a substrate that have been conducted in the past by the inventors, it has turned out that a particle removal rate may be high or low even under the same dissolved gas concentration and the same ultrasonic irradiation conditions. Therefore, it has been difficult to realize a state having a high particle removal rate in a stable manner, simply by adjusting the dissolved gas concentration and the ultrasonic irradiation conditions.

The present invention has been made in light of the aforementioned problem, and an object of the present invention is to provide an ultrasonic cleaning method and an ultrasonic cleaning apparatus by which a high particle removal rate is obtained in a stable manner.

### Means for Solving the Problems

The inventors have earnestly studied a relationship between the dissolved gas concentration and the particle removal rate, and as a result, have obtained the following findings. Specifically, the inventors of the present invention have found that, by introducing a gas into a liquid having a certain range of dissolved gas concentration while irradiating the liquid with ultrasonic waves, the particle removal rate of the liquid can be increased, and the inventors of the present invention have arrived at the present invention.

An ultrasonic cleaning as defined in claim 1 is an ultrasonic cleaning method for cleaning an object to be cleaned in a liquid in which a gas is dissolved, by irradiating the liquid with ultrasonic waves, and the method has the following steps. The liquid in which the gas is dissolved is prepared. Bubbles are generated in the liquid while the liquid is irradiated with the ultrasonic waves, and a state where the bubbles containing the gas dissolved in the liquid continue to be generated is realized. The object to be cleaned is cleaned in the state where the bubbles containing the gas continue to be generated.

In the ultrasonic cleaning method according to the present invention, the bubbles are generated in the liquid while the liquid is irradiated with the ultrasonic waves. Therefore, it is possible to realize the state where the bubbles containing the gas dissolved in the liquid are more likely to be generated continuously. Since cleaning is done in this state, a high particle removal rate can be obtained in a stable manner.

In the ultrasonic cleaning method, the step of realizing a state where bubbles containing the gas continue to be generated is triggered by dispersion, by the ultrasonic waves, of the bubbles introduced into the liquid from outside. Since the bubbles are introduced from outside, the particle removal rate can be increased by a simplified method. In addition, since the bubbles are dispersed by the ultrasonic waves, bubbles serving as nuclei are more likely to be generated. Therefore, it is possible to realize the state where the bubbles are more likely to be generated continuously.

In the ultrasonic cleaning method, the step of cleaning the object to be cleaned includes a step in which sonoluminescence occurs. With this, a high particle removal rate is obtained in a more stable manner.

Preferably, in the ultrasonic cleaning method, the gas is nitrogen and a dissolved gas concentration in the liquid is 5 ppm or more and less than 11 ppm. An ultrasonic cleaning apparatus suitable to execute the present invention is an ultrasonic cleaning apparatus for cleaning an object to be cleaned in a liquid in which a gas is dissolved, by irradiating the liquid with ultrasonic waves, the apparatus having: irradiation means for irradiating the liquid with the ultrasonic waves; a container for containing the liquid; and a mechanism for introducing a gas into the liquid. With the mechanism for introducing a gas into the liquid, it is possible to realize the state where the bubbles serving as nuclei are more likely to be generated in the liquid. As a result, the cleaning effect can be enhanced and a high particle removal rate is obtained in a stable manner.

### Effects of the Invention

According to the present invention, there can be provided an ultrasonic cleaning method by which a high particle removal rate is obtained in a stable manner.

### Brief Description of the Drawings

Fig. 1 is a schematic view showing an ultrasonic cleaning apparatus suitable to execute the present invention.
Fig. 2 shows one example of an apparatus configuration when sonoluminescence is observed.
Fig. 3(a) is a diagram for describing a state of a bubble in a supersaturated state, Fig. 3(b) is a diagram for describing a state of a bubble in a nucleus formation state, Fig. 3(c) is a diagram for describing a state of a bubble in a bubble growth state, Fig. 3(d) is a diagram for describing a state of a bubble in a bubble growth state, and Fig. 3(e) is a diagram for describing a state of a bubble in a bubble burst state.
Fig. 4 is a schematic view showing a relationship between the dissolved nitrogen concentration and the presence or absence of foggy bubbles.
Fig. 5 is a flowchart showing an ultrasonic cleaning method according to one embodiment of the present invention.

### Description of the Reference Characters

- 1: liquid
- 2: gas
- 3: bubble
- 4: bubble introducing tube
- 10: supply means
- 11: first supply valve
- 12: second supply valve
- 20: cleaning tank
- 21: indirect water tank
- 22: holding portion
- 23: liquid introducing pipe
- 30: irradiation means
- 40: monitoring means
- 41: extraction pipe
- 42: pump
- 43: dissolved nitrogen concentration meter
- 50: dark room
- 60: light emission detecting apparatus
- 61: image processing apparatus
- 100: ultrasonic cleaning apparatus
- G: gas
- W: wafer

### Best Modes for Carrying Out the Invention

An embodiment of the present invention will be described hereinafter with reference to the drawings, in which the same reference characters are given to the same or corresponding portions and description thereof will not be repeated.

First, a configuration of an ultrasonic cleaning apparatus suitable to execute the present invention will be described.

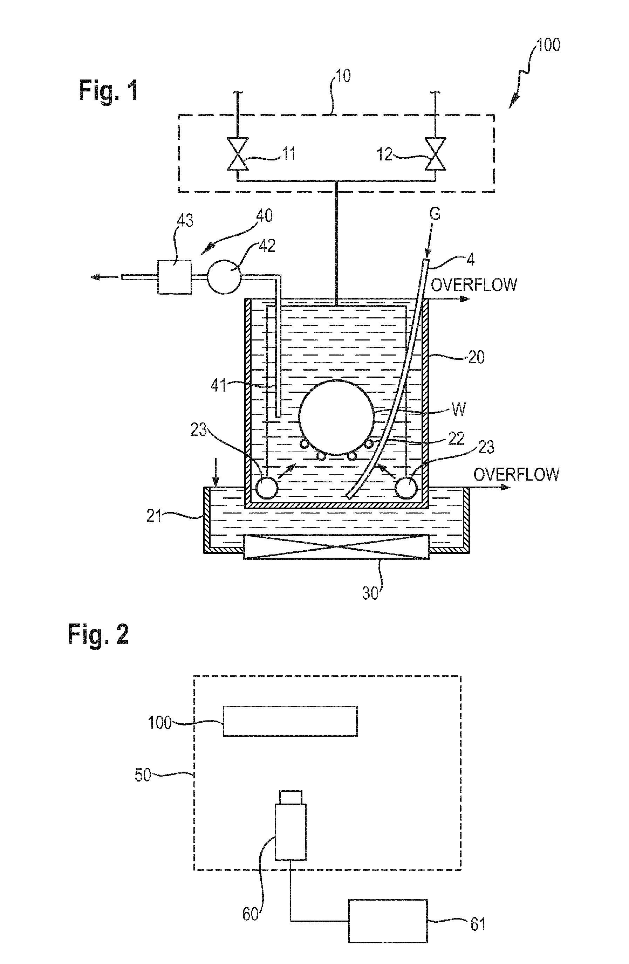

As shown in Fig. 1, an ultrasonic cleaning apparatus 100 has: a cleaning tank 20 containing therein a cleaning liquid such as ultrapure water; supply means 10 for supplying the cleaning liquid to this cleaning tank 20; an indirect water tank 21 storing cleaning tank 20; irradiation means 30 arranged at the bottom of indirect water tank 21, for providing ultrasonic waves; monitoring means 40 for monitoring a dissolved nitrogen concentration in the cleaning liquid supplied into cleaning tank 20; and a bubble introducing tube 4 serving as a mechanism for introducing a gas G into the liquid. Supply means 10 has a first supply valve 11 for supplying ultrapure water in which a nitrogen gas is dissolved to cleaning tank 20, and a second supply valve 12 for supplying degassed ultrapure water to cleaning tank 20.

First supply valve 11 is connected to a not-shown first tank. The ultrapure water in which the nitrogen gas is dissolved is stored in the first tank. Second supply valve 12 is connected to a not-shown degassed water manufacturing apparatus. Ultrapure water is supplied to the degassed water manufacturing apparatus, where a dissolved gas in the ultrapure water can be removed through a degassing membrane. The ultrapure water in which the nitrogen gas is dissolved and the degassed ultrapure water are mixed because pipes connected to first supply valve 11 and second supply valve 12 merge into one pipe on the downstream side of first supply valve 11 and second supply valve 12. A mixing tank (not shown) may be arranged on the downstream side of first supply valve 11 and second supply valve 12. In this case, the ultrapure water in which the nitrogen gas is dissolved and the degassed ultrapure water can be completely mixed in this mixing tank.

The mixed ultrapure water is then supplied to a liquid introducing pipe 23 through a pipe connected to the downstream side of aforementioned first supply valve 11 and second supply valve 12 and disposed within cleaning tank 20. Liquid introducing pipe 23 is disposed near an outer circumferential end of the bottom surface of cleaning tank 20. By adjusting the degree of opening of first supply valve 11 and second supply valve 12, the dissolved nitrogen concentration in the ultrapure water introduced into cleaning tank 20 as well as an amount of supply thereof can be controlled.

Liquid introducing pipe 23 is provided with a plurality of not-shown nozzles. Through these nozzles, the ultrapure water, which is the cleaning liquid, is supplied from liquid introducing pipe 23 into cleaning tank 20. The plurality of nozzles are spaced apart from one another along the direction in which liquid introducing pipe 23 extends. These nozzles are arranged so as to inject the cleaning liquid toward almost the central portion of cleaning tank 20 (region where a wafer W, which is an object to be cleaned, is held).

Cleaning tank 20 is a container for containing the cleaning liquid and a holding portion 22 for holding wafer W is disposed within cleaning tank 20. For example, wafer W is a semiconductor wafer. With wafer W being held by holding portion 22 in cleaning tank 20, the cleaning liquid constituted by the aforementioned mixed ultrapure water is supplied from liquid introducing pipe 23 into cleaning tank 20.

As described above, liquid introducing pipe 23 is disposed at the lower part of cleaning tank 20 (near the bottom wall or in a region located at the outer circumferential portion of the bottom wall that connects the bottom wall and the sidewall). A prescribed amount of the cleaning liquid (mixed ultrapure water) is supplied from liquid introducing pipe 23 into cleaning tank 20. The amount of supply of the cleaning liquid is adjusted such that cleaning tank 20 is filled with the cleaning liquid and a prescribed amount of the cleaning liquid overflows from the upper part of cleaning tank 20. As a result, wafer W is immersed in the cleaning liquid in cleaning tank 20 as shown in Fig. 1.

A supply line (not shown) for a medium different from the medium supplied by aforementioned supply means 10 is connected to indirect water tank 21. Water serving as the medium is supplied from this supply line into indirect water tank 21. At least the bottom wall of aforementioned cleaning tank 20 is in contact with the water stored in indirect water tank 21. A prescribed amount of the water continues to be supplied from the supply line to indirect water tank 21, and thereby a certain amount of the water overflows from indirect water tank 21.

Irradiation means 30 is arranged to be connected to the bottom wall of indirect water tank 21. Irradiation means 30 irradiates the water in indirect water tank 21 with ultrasonic waves. The irradiated ultrasonic waves are provided through the water in indirect water tank 21 and a portion of cleaning tank 20 that is in contact with the water (e.g., the bottom wall) to the cleaning liquid in cleaning tank 20 and wafer W.

Irradiation means 30 can generate ultrasonic waves having a frequency of 20 kHz or more and 2 MHz or less and a watt density of 0.05 W/cm² or more and 7.0 W/cm² or less, for example. Since the cleaning liquid and wafer W are irradiated with the ultrasonic waves in such a manner, wafer W immersed in the cleaning liquid can be efficiently cleaned. Ultrasonic waves having a frequency range of 400 kHz or more and 1 MHz or less are preferably used as the ultrasonic waves irradiated by irradiation means 30.

Monitoring means 40 includes: an extraction pipe 41 extracting a prescribed amount of the cleaning liquid from inside cleaning tank 20; a pump 42 connected to extraction pipe 41, for introducing the cleaning liquid to a dissolved nitrogen concentration meter 43; and dissolved nitrogen concentration meter 43 connected to the downstream side of pump 42. Data of the measured dissolved nitrogen concentration in the cleaning liquid is output from dissolved nitrogen concentration meter 43 to a display unit included in dissolved nitrogen concentration meter 43. An apparatus having an arbitrary configuration can be used as dissolved nitrogen concentration meter 43. For example, a measuring apparatus can be used, in which a dissolved gas component contained in the cleaning liquid is introduced into a receptor through a polymer film and a concentration of the gas component is calculated based on a change in thermal conductivity in this receptor.

Cleaning tank 20 is made of, for example, quartz glass having a thickness of 3.0 mm. Cleaning tank 20 can have an arbitrary shape. For example, a square water tank having a width of 270 mm, a depth of 69 mm and a height of 270 mm in terms of inside dimension is used as cleaning tank 20. A cleaning tank 20 with these dimensions has a capacity of 5 liters.

The thickness of the quartz glass plate material forming the bottom wall of cleaning tank 20 is preferably adjusted as appropriate, depending on the frequency of the ultrasonic waves emitted from irradiation means 30. For example, when the frequency of the ultrasonic waves emitted from irradiation means 30 is 950 kHz, the thickness of the plate material forming the bottom wall is preferably 3.0 mm. When the frequency of the ultrasonic waves emitted from irradiation means 30 is 750 kHz, the thickness of the plate material forming the bottom wall is preferably 4.0 mm, for example.

The amount of the cleaning liquid (mixed ultrapure water) supplied from supply means 10 to cleaning tank 20 may be 5 liters/min. The frequency of the ultrasonic waves irradiated by irradiation means 30 may be 950 kHz and 750 kHz as described above, and an output thereof may be 1200 W (watt density of 5.6 W/cm²). A radiation surface of a vibrating plate in irradiation means 30 may have a size of 80 mm x 270 mm.

The mechanism for introducing a gas G into the liquid has, for example, bubble introducing tube 4. One end of the bubble introducing tube is disposed at a position near the bottom surface of cleaning tank 20 and is immersed in the liquid. The other end of the bubble introducing tube is connected to, for example, a gas supply unit (not shown). The gas supply unit is configured to be capable of supplying a gas G to the liquid through the bubble introducing tube. An opening at the one end of the bubble introducing tube has a size of approximately 5 mm, for example. The gas supply unit can supply approximately 1 mL to 10 mL of the gas, for example.

An apparatus configuration when sonoluminescence (light emission phenomenon occurring when the cleaning liquid containing dissolved gas is irradiated with ultrasound) is observed will be described with reference to Fig. 2. First, ultrasonic cleaning apparatus 100 and a light emission detecting apparatus 60 are disposed within a dark room 50. Light emission detecting apparatus 60 is connected to an image processing apparatus 61. An image intensifier unit (extremely weak light sensing and intensifying unit) used as light emission detecting apparatus 60 is an apparatus for sensing and intensifying extremely weak light to obtain a contrasty image. Specifically, a unit using an image intensifier (V4435U-03) manufactured by Hamamatsu Photonics K.K. can be used as this unit. In this unit, a photoelectric surface is made of Cs-Te, a sensitivity wavelength range is from 160 to 320 nm, and the highest sensitivity wavelength is 250 nm. It is believed that light emission when water is irradiated with ultrasonic waves is caused by hydroxy radical (OH radical) that occurs as a result of decomposition of the water, and the light emission has a wavelength in an ultraviolet region of around 309 nm. Therefore, the image intensifier unit having the photoelectric surface material (Cs-Te) and having the aforementioned wavelength as the sensitivity wavelength range is used. A photomultiplier may be used as light emission detecting apparatus 60. Conditions of the apparatus include, for example, an ultrasonic frequency, an ultrasonic intensity, a design of a water tank containing a solution, an amount of supply of the solution, and the like.

Next, an ultrasonic cleaning method according to the present embodiment will be described.

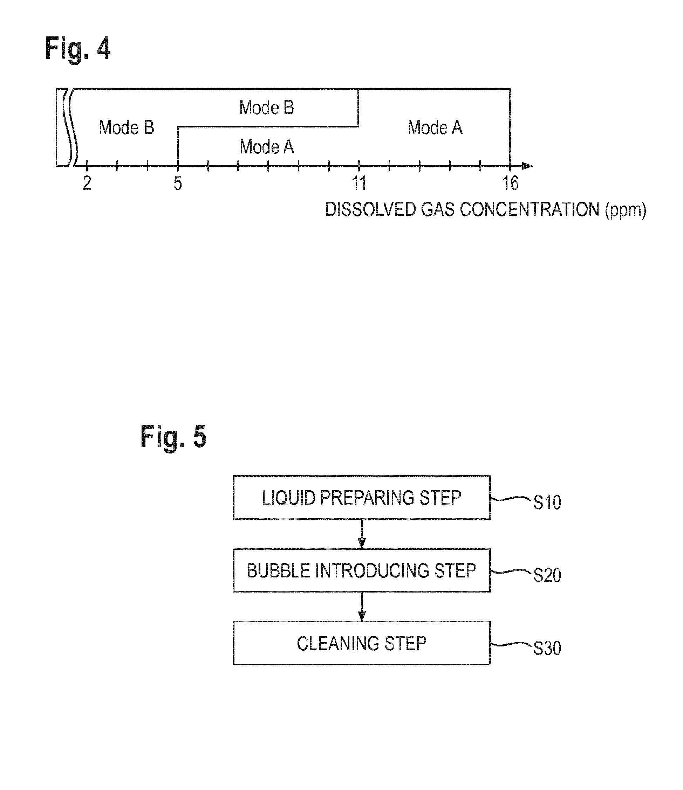

The ultrasonic cleaning method according to the present embodiment will be described with reference to Fig. 5. The ultrasonic cleaning method according to the present embodiment is a method for cleaning wafer W (object to be cleaned) immersed in a liquid in which a gas such as nitrogen is dissolved, by irradiating the liquid with ultrasonic waves, and the method mainly has the following steps.

First, a liquid preparing step (S10) is performed. For example, using the cleaning apparatus shown in Fig. 1, ultrapure water in which a nitrogen gas is dissolved and degassed ultrapure water are mixed, and a liquid (cleaning liquid) having a desired dissolved nitrogen concentration is prepared. The dissolved nitrogen concentration in the liquid is preferably 5 ppm or more and less than 11 ppm.

Next, a bubble introducing step (S20) is performed. Specifically, the liquid prepared in the aforementioned step (S10) is irradiated with ultrasonic waves. In this state, sonoluminescence has not yet occurred. A gas is introduced into the liquid while the liquid is irradiated with the ultrasonic waves. For example, the gas is introduced into the liquid from outside using bubble introducing tube 4 shown in Fig. 1, and thereby bubbles are generated in the liquid. Although gas G introduced into the liquid is, for example, nitrogen, gas G is not limited thereto. The gas introduced into the liquid may be, for example, argon (Ar), helium (He), air and the like. From the viewpoint of generating the bubbles in the liquid, it is desirable to use a gas having a low degree of solubility in water, which is the liquid.

Gas G introduced into the liquid has a volume of, for example, 10 mL. Preferably, gas G introduced into the liquid has a volume of 1 mL or more. A pressure of gas G may be any pressure as long as it overcomes the pressure of the liquid and allows formation of the bubbles.

After gas G is introduced into the liquid, large bubbles are observed in the liquid. Thereafter, the bubbles are destroyed and dispersed by the ultrasonic waves. Thereafter, about 4 seconds after the bubbles are introduced into the liquid, for example, foggy bubbles are generated in the liquid. The foggy bubbles are bubbles containing the gas (nitrogen in the present embodiment) dissolved in the liquid. In such a manner, a state where the bubbles containing the dissolved gas (e.g. nitrogen) continue to be generated is realized. The state where the minute bubbles continue to be generated due to the dissolved gas is called "cavitation phenomenon". The state where the bubbles containing the dissolved gas (e.g. nitrogen) continue to be generated is thus initiated by the external introduction of gas bubbles into the cleaning liquid, e.g. using bubble introducing tube 4. After initiating this state, it can be maintained by continuing the irradiation with ultrasound. It is not necessary to continue introducing gas bubbles into the liquid in order to maintain this state.

In the ultrasonic cleaning method according to the present embodiment, after gas G is introduced into the liquid, sonoluminescence occurs. Sonoluminescence can be sensed by the image intensifier and the photomultiplier shown in Fig. 2. Next, a cleaning step (S30) is performed. In the cleaning step, wafer W, which is the object to be cleaned, is cleaned in the state where the bubbles containing nitrogen continue to be generated. Sonoluminescence is occurring in the cleaning step.

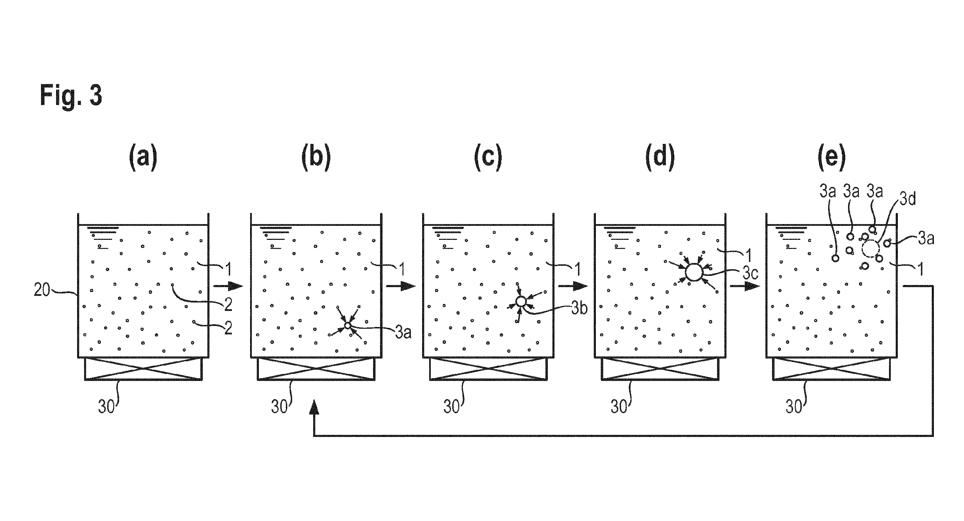

Next, a hypothesis about a mechanism of a chain reaction of the cavitation phenomenon that is caused by introducing the gas into the liquid will be described with reference to Figs. 3(a) to 3(e).

Referring to Fig. 3(a), a liquid 1 in which nitrogen 2 is dissolved is irradiated with ultrasonic waves by irradiation means 30. In this liquid, nitrogen 2 is supersaturated. Referring to Fig. 3(b), a gas is introduced into the liquid from outside, and thereby a bubble 3a is generated in the liquid. Bubble 3a serves as a nucleus and the neighboring dissolved gas gathers around bubble 3a. Referring to Figs. 3(c) and 3(d), a grown bubble 3b moves through the liquid while collecting the neighboring dissolved gas one after another, and grows into a bubble 3c having a size that resonates with the ultrasonic waves. Referring to Fig. 3(e), a bubble 3d that has grown to the size that resonates with the ultrasonic waves bursts and produces a plurality of small bubbles 3a. It is considered that the burst of bubble 3d causes a shock wave in the liquid, which allows removal of particles attached to an object to be cleaned. The plurality of small bubbles 3a also serve as nuclei and start to collect the neighboring dissolved gas. In such a manner, the bubbles containing the dissolved gas are generated continuously. Regarding a change in the bubbles shown in Figs. 3(b) to 3(e) as one loop, this loop is repeated approximately 1000 times or more in one second. It is considered that generation of the bubbles in the liquid means supply of the first bubble that triggers the chain reaction of generation of the bubbles.

Next, the function and effect of the present embodiment will be described.

In the ultrasonic cleaning method according to the present embodiment, the bubbles are generated in the liquid while the liquid is irradiated with the ultrasonic waves. Therefore, it is possible to realize the state where the bubbles containing the gas dissolved in the liquid continue to be generated. Since cleaning is done in this state, a high particle removal rate can be obtained in a stable manner.

In addition, in the ultrasonic cleaning method according to the present embodiment, the step of realizing the state where the bubbles containing the gas continue to be generated is triggered by dispersion, by the ultrasonic waves, of the bubbles introduced into the liquid from outside. Since the bubbles are introduced from outside, the particle removal rate can be increased by a simplified method. In addition, since the bubbles are dispersed by the ultrasonic waves, the bubbles serving as nuclei are more likely to be generated. Therefore, it is possible to realize the state where the bubbles are more likely to be generated continuously.

Furthermore, in the ultrasonic cleaning method according to the present embodiment, the step of cleaning wafer W, which is the object to be cleaned, includes a step in which sonoluminescence occurs. With this, a high particle removal rate is obtained in a stable manner.

The ultrasonic cleaning apparatus according to the present embodiment has bubble introducing tube 4. Since the gas is introduced into the liquid using the bubble introducing tube, it is possible to realize the state where the bubbles serving as nuclei are more likely to be generated in the liquid. As a result, the cleaning effect can be enhanced and a high particle removal rate is obtained in a stable manner.

### Example 1

An object of this experiment is to verify a difference in the rate of removal of particles attached to wafer W between the cleaning method according to the present invention and a cleaning method according to a comparative example that are used to clean wafer W.

First, a cleaning apparatus used in this experiment will be described with reference to Fig. 1. The square water tank made of quartz glass having a thickness of 3.0 mm was used as cleaning tank 20 in the experiment. The water tank had a width of 270 mm, a depth of 69 mm and a height of 285 mm in terms of inside dimension. The plate material forming the bottom wall had a thickness of 4.0 mm. Cleaning tank 20 had a capacity of 5 liters.

The amount of the cleaning liquid (mixed ultrapure water) supplied from supply means 10 to cleaning tank 20 was 5 liters/min. The frequency of the ultrasonic waves irradiated by irradiation means 30 was 750 kHz and the output thereof was 1200 W (watt density of 5.6 W/cm²). The radiation surface of the vibrating plate in irradiation means 30 had a size of 80 mm x 270 mm. The ultrasonic waves emitted from irradiation means 30 were provided onto the entire bottom surface of cleaning tank 20.

First supply valve 11 adjusting the amount of supply of the ultrapure water in which the nitrogen gas was dissolved and second supply valve 12 adjusting the amount of supply of the degassed water were controlled, and thereby the ultrapure water in which nitrogen was dissolved was supplied to cleaning tank 20 at 5 liters/min. The ultrapure water in the water tank was sampled and the dissolved nitrogen concentration was measured by monitoring means 40.

Next, an object to be cleaned that is used to measure the particle removal rate will be described.

A P-type silicon wafer having a diameter of 200 mm was used as the object to be cleaned. Silicon dioxide particles were attached to a mirror surface of the P-type silicon wafer by spin coating. An amount of attachment was 2000 to 3000 particles in the case of the particles of 110 nm or more.

Next, a method for measuring the particle removal rate will be described.

The wafer having the silicon dioxide particles attached thereto was immersed in the water tank and cleaned for 10 minutes. Thereafter, the wafer was dried for 2 minutes by a spin dryer. The particle removal rate is obtained as a value acquired by dividing the number of particles that decrease after cleaning by the number of particles attached to the wafer before cleaning, and this value is expressed as a percentage. LS6500 manufactured by Hitachi High-Technologies Corporation was used to measure an amount of particle attachment.

### Example according to the Present Invention

The cleaning method according to an example of the present invention will be described. First, a cleaning liquid whose dissolved nitrogen concentration was adjusted to 6 ppm was prepared. This cleaning liquid was irradiated with ultrasonic waves by irradiation means 30. The frequency of the irradiated ultrasonic waves was 750 kHz and the output thereof was 1200 W. The cleaning liquid was continuously irradiated with the ultrasonic waves. The nitrogen gas was introduced into the cleaning liquid using bubble introducing tube 4 while the cleaning liquid was irradiated with the ultrasonic waves. The introduced nitrogen gas had a volume of approximately 10 mL. After 4 seconds elapsed from introduction of the nitrogen gas into the liquid, foggy bubbles were generated in the cleaning liquid. At this point, an observation by the image intensifier unit was conducted. Then, occurrence of sonoluminescence was seen. Wafer W having the silicon dioxide particles attached thereto, which was the object to be cleaned, was immersed in the liquid having the foggy bubbles, and wafer W was cleaned for 10 minutes, and thereafter, wafer W was dried for 2 minutes by the spin dryer.

### Comparative Example

Next, the cleaning method according to the comparative example will be described. First, a cleaning liquid whose dissolved nitrogen concentration was adjusted to 6 ppm was prepared. This cleaning liquid was irradiated with ultrasonic waves by irradiation means 30. The frequency of the irradiated ultrasonic waves was 750 kHz and the output thereof was 1200 W. The cleaning liquid was continuously irradiated with the ultrasonic waves. Unlike the cleaning method according to the example of the present invention, the nitrogen gas was not introduced into the cleaning liquid in the cleaning method according to the comparative example. An observation by the image intensifier unit was conducted. Then, occurrence of sonoluminescence was not seen. Wafer W having the silicon dioxide particles attached thereto, which was the object to be cleaned, was immersed in the liquid, and wafer W was cleaned for 10 minutes, and thereafter, wafer W was dried for 2 minutes by the spin dryer.

### Particle Removal Rate

Next, a result of the particle removal rate will be described. The particle removal rate in the cleaning method according to the comparative example was 18.8 %. On the other hand, the particle removal rate in the cleaning method according to the example of the present invention was 30.5 %. Based on this experiment, it was seen that by generating the bubbles in the cleaning liquid while irradiating the cleaning liquid with the ultrasonic waves, the particle removal rate is increased.

### Example 2

An object of this experiment is to examine a range of the dissolved nitrogen concentration for generating the foggy bubbles in the cleaning liquid.

First, seven types of cleaning liquids having dissolved nitrogen concentrations of 1.9 ppm, 4.9 ppm, 6.0 ppm, 7.8 ppm, 9.6 ppm, 11.0 ppm, and 15.7 ppm, respectively, were prepared. The nitrogen gas was introduced into each of these seven types of cleaning liquids using bubble introducing tube 4 while each of the cleaning liquids was irradiated with ultrasonic waves. The frequency of the irradiated ultrasonic waves was 750 kHz and the output thereof was 1200 W. The introduced nitrogen gas had a volume of approximately 10 mL. After the nitrogen gas was introduced into the cleaning liquids, it was observed whether or not the foggy bubbles were generated in the cleaning liquids.

A result of this experiment will be described with reference to Fig. 4. In the specification, a state where the foggy bubbles are generated in the cleaning liquid will be referred to as "Mode-A", and a state where the foggy bubbles are not generated in the cleaning liquid will be referred to as "Mode-B". Alternatively, Mode-A refers to a state where the particle removal rate is high, i.e., approximately 30.5 %, and Mode-B refers to a state where the particle removal rate is low, i.e., approximately 18.8 %.

When the dissolved nitrogen concentration was 4.9 ppm or less, the foggy bubbles were not observed in the cleaning liquids (Mode-B). When the dissolved nitrogen concentration was 6.0 ppm or more and 9.6 ppm or less, the foggy bubbles were not generated in the cleaning liquids (Mode-B) before the nitrogen gas was introduced into the cleaning liquids using bubble introducing tube 4. However, the foggy bubbles were generated in the cleaning liquids (Mode-A) after the nitrogen gas was introduced into the cleaning liquids using bubble introducing tube 4. Furthermore, when the dissolved nitrogen concentration was 11.0 ppm or more and 15.7 ppm or less, the foggy bubbles were generated in the cleaning liquids (Mode-A) before and after the nitrogen gas was introduced into the cleaning liquids using bubble introducing tube 4. Based on the aforementioned experiment, it is considered that by introducing the nitrogen gas into the cleaning liquid when the dissolved nitrogen concentration in the cleaning liquid is 5 ppm or more and less than 11 ppm, the state of the cleaning liquid can be changed from Mode-B to Mode-A.

It should be understood that the embodiment and the examples disclosed herein are illustrative and not limitative in any respect. The scope of the present invention is defined by the terms of the claims, rather than the embodiment and the examples above.

## Claims

1. An ultrasonic cleaning method for cleaning an object (W) to be cleaned in a liquid in which a first gas is dissolved, by irradiating said liquid with ultrasonic waves, the method comprising the steps of:
- preparing said liquid in which said first gas is dissolved;
- introducing a second gas (G) into said liquid while irradiating said liquid with the ultrasonic waves, and realizing a state where bubbles containing said first gas dissolved in said liquid continue to be generated triggered by dispersion, by the ultrasonic waves, of the bubbles generated by introducing said second gas (G) into said liquid; and
cleaning said object (W) to be cleaned in the state where the bubbles containing said first gas continue to be generated and wherein the step of cleaning said object to be cleaned includes a step in which sonoluminescence occurs.

2. The ultrasonic cleaning method according to claim 1 wherein said gas is nitrogen and a dissolved gas concentration in said liquid is 5 ppm or more and less than 11 ppm.

## Patentansprüche

1. Ultraschallreinigungsverfahren zum Reinigen eines Objekts (W), das in einer Flüssigkeit gereinigt werden soll, in der ein erstes Gas gelöst ist, durch Bestrahlen der Flüssigkeit mit Ultraschallwellen, wobei das Verfahren die folgenden Schritte umfasst:
- Herstellen der Flüssigkeit, in der das erste Gas gelöst ist;
- Einleiten eines zweiten Gases (G) in die Flüssigkeit während des Bestrahlens der Flüssigkeit mit den Ultraschallwellen und Realisieren eines Zustandes, in dem das in der Flüssigkeit gelöste erste Gas enthaltende Blasen weiter generiert werden, ausgelöst durch Dispersion, durch die Ultraschallwellen, der durch Einleiten des zweiten Gases (G) in die Flüssigkeit generierten Blasen; und
Reinigen des zu reinigenden Objekts (W) in dem Zustand, in dem die das erste Gas enthaltenden Blasen weiterhin generiert werden und wobei der Schritt des Reinigens des zu reinigenden Objekts einen Schritt beinhaltet, bei dem Sonolumineszenz auftritt.

2. Ultraschallreinigungsverfahren nach Anspruch 1, wobei das Gas Stickstoff ist und eine gelöste Gaskonzentration in der Flüssigkeit 5 ppm oder mehr und weniger als 11 ppm ist.

## Revendications

1. Procédé de nettoyage par ultrasons destiné à nettoyer un objet (W) devant être nettoyé dans un liquide dans lequel un premier gaz est dissous, par irradiation dudit liquide avec des ondes ultrasonores, le procédé comprenant les étapes consistant à :
- préparer ledit liquide dans lequel ledit premier gaz est dissous ;
- introduire un deuxième gaz (G) dans ledit liquide tout en irradiant ledit liquide avec les ondes ultrasonores, et établir un état où des bulles contenant ledit premier gaz dissous dans ledit liquide continuent à être générées déclenchées par dispersion, par les ondes ultrasonores, des bulles générées en introduisant ledit deuxième gaz (G) dans ledit liquide ; et
- nettoyer ledit objet (W) devant être nettoyé dans l'état où les bulles contenant ledit premier gaz continuent à être générées, et dans lequel l'étape de nettoyage dudit objet devant être nettoyé comporte une étape dans laquelle une sonoluminescence se produit.

2. Procédé de nettoyage par ultrasons selon la revendication 1 dans lequel ledit gaz est l'azote et la concentration de gaz dissous dans ledit liquide est supérieure ou égale à 5 ppm et inférieure à 11 ppm.
